# EUROPEAN PATENT SPECIFICATION

(11) **EP 2 705 736 B1**
(45) Date of publication and mention of the grant of the patent: **27.03.2019**
(21) Application number: 12780038.1
(22) Date of filing: 26.04.2012
(51) Int. Cl.: H01L 23/31, H01L 23/498, H01L 21/48, H05K 1/02, H05K 3/38, H05K 3/40

(54) **THE PRINTED CIRCUIT BOARD AND THE METHOD FOR MANUFACTURING THE SAME**
BESTÜCKTE OPTISCHE LEITERPLATTE UND VERFAHREN ZU IHRER HERSTELLUNG
CARTE DE CIRCUIT IMPRIMÉ ET PROCÉDÉ DE FABRICATION DE CELLE-CI

(30) Priority: 03.05.2011 KR 20110042157
(43) Date of publication of application: 12.03.2014
(73) Proprietor: LG Innotek Co., Ltd., Seoul, 04637 (KR)
(72) Inventor: PARK, Chung Sik, Seoul 100-714 (KR); KIM, Duk Nam, Seoul 100-714 (KR); AHN, Jae Hyun, Seoul 100-714 (KR)
(74) Representative: Novagraaf Technologies
(86) International application number: PCT/KR2012/003236
(87) International publication number: WO 2012/150777

(56) References cited:
- JP-A- 2004 104 045
- JP-A- 2004 104 045
- JP-A- 2008 205 014
- KR-A- 20110 011 067
- US-A1- 2004 201 096

## Description

### Technical Field

The present invention relates to a printed circuit board and a method for manufacturing the same.

### Background Art

Circuit boards refer to electrical insulating substrates printed with circuit patterns, and are used to mount electronic components thereon.

Recently, among the circuit boards, a thin multi-layer circuit board has been suggested. To manufacture the thin multi-layer circuit board, various attempts of forming a thin support substrate to support the bending of an intermediate central layer during a process for the intermediate central layer have been suggested.

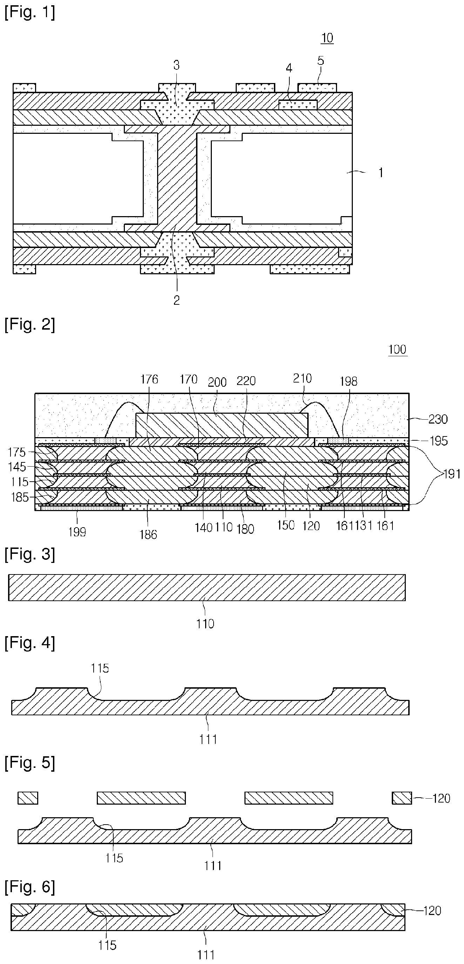

FIG. 1 is a sectional view showing a printed circuit board 10 according to the related art.

The printed circuit board 10 according to the related art includes multi-layer circuit patterns 4 and 5 formed between a plurality of multi-layer insulating layers 1, and is formed therein with vias 2 and 3 used to connect the circuit patterns 4 and 5 to each other.

In this case, the vias 2 and 3 are filled with conductive paste after a mechanical hole process has been performed, or formed through a plating process after a hole process has been performed through a laser drill scheme.

In this case, the scheme of forming the via 2 by using the conductive paste is employed when the plating scheme may not be employed due to the great size of the via 2. However, the via 2 formed by the conductive paste represents great electrical resistance, so that the transmission signal may have noise. Accordingly, the reliability may be degraded.

Meanwhile, in the case of the via 3 formed through a laser drilling scheme, a hole process is required with respect to each insulating layer 1, so that the economical problem is caused.

### Disclosure of Invention

### Technical Problem

The embodiment provides a printed circuit board having a novel structure and a method for manufacturing the same.

The embodiment provides a printed circuit board and a method for manufacturing the same, in which vias are formed through a simple process.

### Solution to Problem

According to the invention, there is provided a printed circuit board as defined in claim 1.

According to the invention, there is provided a method for manufacturing a printed circuit board as defined in claim 11.

### Advantageous Effects of Invention

As described above, according to the present invention, the adhesive property between the copper layer and the insulating layer is improved, and bulk copper is used, so that the heat radiation property can be improved.

In addition, the vias used to connect interlayer circuits to each other are formed between a plurality of insulating layers through an etching process instead of a laser process or a polishing process, so that the process ability can be improved, and the manufacturing cost can be reduced.

### Brief Description of Drawings

FIG. 1 is a sectional view showing a printed circuit board according to the related art;
FIG. 2 is a sectional view showing a device chip package employing a printed circuit board according to the embodiment of the present invention;
FIGS. 3 to 16 are sectional views showing a method for manufacturing the printed circuit board of FIG. 2; and
FIG. 17 is a sectional view showing a device chip package employing the printed circuit board of FIG. 2.

### Best Mode for Carrying out the Invention

Hereinafter, embodiments will be described in detail with reference to accompanying drawings so that those skilled in the art can easily work with the embodiments.

However, the embodiments may have various modifications.

However, the present invention can be realized as various modifications, and is not limited to the embodiments.

In the following description, when a predetermined part "includes" a predetermined component, the predetermined part does not exclude other components, but may further include other components if there is a specific opposite description.

The thickness and size of each layer shown in the drawings may be exaggerated, omitted or schematically drawn for the purpose of convenience or clarity. In addition, the size of elements does not utterly reflect an actual size. The same reference numbers will be assigned the same elements throughout the drawings.

In the description of the embodiments, it will be understood that, when a layer (or film), a region, or a plate is referred to as being "on" or "under" another layer (or film), another region, or another plate, it can be "directly" or "indirectly" on the other layer (or film), region, plate, or one or more intervening layers may also be present. Such a position of the layer has been described with reference to the drawings.

The present invention provides a printed circuit board which does not employ a laser drilling scheme when forming a via hole.

Hereinafter, a heat radiating circuit substrate according to the embodiment of the present invention will be described with reference to FIGS. 2 to 16.

FIG. 2 is a sectional view showing a printed circuit board according to the embodiment of the present invention and a device chip package 100 employing the printed circuit board.

Referring to FIG. 2, the device chip package 100 according to the present invention includes the printed circuit board and a device chip 200 mounted on the printed circuit board.

The printed circuit board includes a plurality of insulating layers 120, 150, 176, and 186, a plurality of vias formed through the insulating layers 120, 150, 176, and 186, and a coverlay 195 to cover the vias.

The insulating layers 120, 150, 176, and 186 include the first insulating layer 120, the second insulating layer 150 formed on the first insulating layer 120, and third and fourth insulating layers 176 and 186 formed on the first insulating layer 176 and under the fourth insulating layer 186, respectively.

The first to fourth insulating layers 120, 150, 176, and 186 may include epoxy insulating resin representing low thermal conductivity (about 0.2W/mK to about 0.4W/mk). Alternatively, the first to fourth insulating layers 120, 150, 176, and 186 may include poly imide resin representing high thermal conductivity. In addition, the first to fourth insulating layers 120, 150, 176, and 186 may include the same material. Alternatively, the first to fourth insulating layers 120, 150, 176, and 186 may include materials different from each other.

In addition, the first to fourth insulating layers 120, 150, 176, and 186 are formed by filling adjacent vias with a predetermined material, and have sectional shapes varied according to the shapes of the vias.

The vias may be spaced apart from each other, and may include through vias formed by perforating from the top surface of the printed circuit board to the bottom surface of the printed circuit board.

Each via has a layer structure including a plurality of layers.

Each via includes a first via layer formed by perforating the first insulating layer 120, a second via layer 140 formed through the second insulating layer 150 and aligned with the first via layer 110, and third and fourth via layers 170 and 180 formed on the first via layer 110 and under the second via layer 140, respectively, by perforating the third and fourth insulating layers 176 and 186, respectively.

In this case, although the present invention has been described in that the printed circuit board is limited to a multi-layer structure having four insulating layers 120, 150, 176, and 186, so that the vias are formed in a four layer-structure, the vias may be designed as many as the number of the insulating layers 120, 150, 176, and 186. In addition, the vias has the layer structure having layers, the number of which is fewer than the number of the insulating layers 120, 150, 176, and 186, so that the shape of the filled via can be represented instead of the shape of the through via.

Hereinafter, the via having a four-layer structure will be described.

The first via layer 110 is formed at the central region of the printed circuit board, and has a sectional shape gradually enlarged toward the lower portion thereof.

The second via layer 140 extends from the top surface of the first via layer 110, and has a sectional shape gradually enlarged toward the upper portion thereof.

The third via layer 170 may be formed on the second via layer 140, and may have the same shape as that of the second via layer 140. The fourth via layer 180 may be formed under the first via layer 110, and may have the same shape as that of the first via layer 110.

In other words, the plural layer structure may have a symmetric structure about the central region.

The first to fourth via layers 110, 140, 170, and 180 may include the same material. Preferably, the first to fourth via layers 110, 140, 170, and 180 may include copper which is a conductive material representing superior heat radiation property.

Meanwhile, a plurality of adhesive layers 131, 161, and 191 may be formed between the via layers.

The adhesive layers 131, 161, and 191 include the first adhesive layer 131 formed between the first and second via layers 110 and 140, the second adhesive layers 161 formed between the second and third via layers 140 and 170 and between the first and fourth via layers 110 and 180, respectively, and the third adhesive layers 191 formed on the surface of the third via layer 170, which is exposed through the top surface of the printed circuit board, and formed on the surface of the fourth via layer 180, which is exposed through the bottom surface of the printed circuit board.

The adhesive layers 131, 161, and 191 may include the same material, and used to bond a plurality of via layers formed through different processes to each other. The adhesive layers 131, 161, and 191 may include the same material as that of the via layers.

In other words, the adhesive layers 131, 161, and 191 may include the alloy containing copper.

The printed circuit board is provided on the top and bottom surfaces thereof with coverlays 195, and portions of vias are exposed from the coverlay 195 to form pads 198 and 199.

The pads 198 and 199 may include the alloy containing metal such as silver, gold, nickel or palladium, and include the inner lead 198 formed on a surface having a chip to be formed thereon and the outer lead 199 formed on a rear surface provided in opposition to the surface having the chip to be formed thereon.

A solder paste 220 is coated on the exposed top surface of the via, and the device chip 200 is mounted on the solder paste 220.

The device chip 200 may include a semiconductor chip, a light emitting diode chip, and other driving chips. In addition, the device chip 200 is electrically connected to the inner lead 198 through a wire 210.

The device chip 200 is molded by a resin 230 so that the device chip 200 can be protected from the outside.

Hereinafter, a method for manufacturing the printed circuit board of FIG. 2 will be described with reference to FIGS. 3 to 16.

First, as shown in FIG. 3, the first bulk metallic plate 111 is prepared.

The first bulk metallic plate 111 may include a copper plate having a thickness greater than that of each via layer.

Next, a first insulating groove 115 is formed by etching a space between the vias except for the region for the formation of the via as shown in FIG. 4.

The first insulating groove 115 may be formed by performing a wet etching scheme after a resist pattern is formed on the copper plate 111, and may have a curved section.

Therefore, a protrusion constituting the first via layer 110 is formed between the first insulating grooves 115.

Next, as shown in FIG. 6, after forming a hole corresponding to the first via layer 110 in the first insulating layer 120, the first insulating layer 120 is pressed against the first metallic plate 111, so that the first insulating layer 120 is filled in the first insulating groove 115 of the first metallic plate 111.

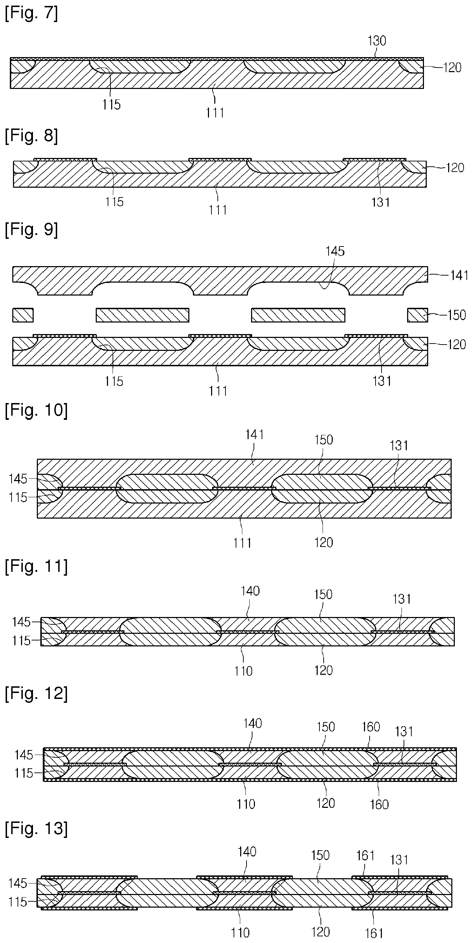

Next, as shown in FIG. 7, the first metallic layer 130 is formed on the first via layer 110 and the first insulating layer 120.

The first metallic layer 130 may be formed by depositing copper through an aerosol deposition scheme. In other words, mixture of the copper and gas is aerosolized and sprayed on the first via layer 110 and the first insulating layer 120 through a nozzle, thereby forming the first metallic layer 130.

When the aerosol deposition is performed in order to form he metallic layer 130, deposition is achieved at a room temperature instead of a high temperature.

Next, as shown in FIG. 8, the first metallic layer 130 is etched except for the upper portion of the first via layer 110, thereby forming the first adhesive layer 131 of FIG. 2.

In this case, the first metallic layer 130 may be etched through a wet etching process after the resist pattern has been formed. In this case, the first adhesive layer 131 has a surface extending to the upper portion of the first insulating layer 120 so that the first adhesive layer 131 has a surface wider than the top surface of the first via layer 110.

Next, as shown in FIG. 9, after forming a second insulating groove 145 in a second metallic plate 141 by repeating the processes of FIGS. 3 to 4, the second metallic plate 141 is arranged in such a manner that the second insulating groove 145 faces the first insulating layer 115. Then, the second insulating layer 150 is provided corresponding to the second insulating groove 145, and heat and pressure are applied to the first and second metallic plates 111 and 141, thereby completing the shape of FIG. 10.

Subsequently, as shown in FIG. 11, both surfaces of the first and second metallic plates 111 and 141 are etched until the first and second insulating layers 120 and 150 are exposed, thereby forming the first and second via layers 110 and 140 of FIG. 2.

Next, as shown in FIG. 12, the second metallic layers 160 are formed on the first and second via layers 110 and 140 and the exposed first and second insulating layers 120 and 150.

Each second metallic layer 160 is formed by using a copper layer through an aerosol deposition scheme as shown in FIG. 7, and portions of the second metallic layers 160 are etched to form the second adhesive layers 161 on the first and second via layers 110 and 140 as shown in FIG. 13.

The second adhesive layer 161 has an area wider than that of the first adhesive layer 131 due to the shapes of the first and second via layers 110 and 140.

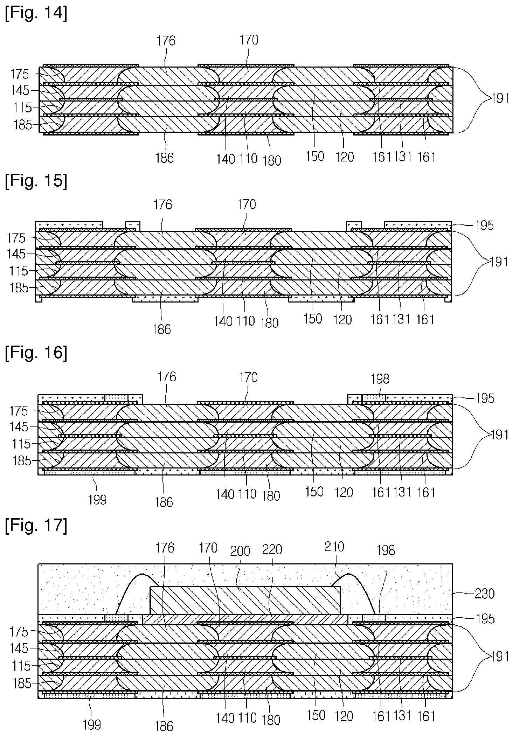

Subsequently, a multi-layer structure of FIG. 14 is formed by repeating the processes of FIGS. 3 to 13.

In the multi-layer structure of FIG. 14, the third via layer 170 is formed on the second via layer 140, the fourth via layer 180 is formed under the first via layer 110, and the third adhesive layers 191 are formed on the exposed surface of the first and fourth via layers 110 and 180.

The third adhesive layers 191 may have the same shape as that of the second adhesive layers 161, and have areas extending to the upper portions of the third and fourth insulating layers 176 and 186.

Subsequently, areas in which the inner lead 198, the outer lead 199, and the device chip 200 are formed are exposed and the coverlay 195 is formed.

The coverlay 195 may include solder resist or a dry film.

Next, the inner lead 198 and the outer lead 199 are formed by plating the exposed surfaces of the coverlay 195. The inner lead 198 and the outer lead 199 may include the alloy containing metal such as silver, gold, nickel, or palladium, and may be subject to plating, so that the inner lead 198 and the outer lead 199 may have a multi-layer structure.

As shown in FIG. 16, if the pads of the inner lead 198 and the outer lead 199 are formed, the printed circuit board is completed.

As shown in FIG. 17, after coating the solder paste 220 on the mounting region of the device chip 200 of the printed circuit board of FIG. 16, the device chip 200 is mounted, and the device chip 200 is electrically conducted with the inner lead 198 through the wire 210, thereby completing the package 100 of the device chip 200.

As described above, when forming a multi-layer via in the printed circuit board having a multi-layer insulating layer, the via is formed through the etching process, so that the cost can be reduced. In addition, the adhesive layer is formed between via layers, so that an adhesive strength and a signal characteristic can be ensured.

Although exemplary embodiments of the present invention have been described for illustrative purposes, those skilled in the art will appreciate that various modifications, additions and substitutions are possible, without departing from the scope of the invention as disclosed in the accompanying claims.

## Claims

1. A printed circuit board comprising:
a first insulating layer (120);
a second insulating layer (150) on the first insulating layer; and
a first via layer (110) formed through the first insulating layer (120) and having a height equal to a height of the first insulating layer (120);
a second via layer (140) on the first via layer while passing through the second insulating layer (150) and having a height equal to a height of the second insulating layer (150); and
an adhesive layer (131) between the first and second via layers, and
wherein the section of the first via layer (110) is symmetrical to the section of the second via layer about the adhesive layer; and
wherein each of the first (110) and second via layers (140) is a single layer.

2. The printed circuit board of claim 1, wherein the sections of the first and second via layers are enlarged as the first and second via layers are away from the adhesive layer.

3. The printed circuit board of claim 2, wherein lateral sides of the first and second via layers are recessed in a concave shape.

4. The printed circuit board of claim 1, wherein the first (110) and second via layers (140) includes a conductive material such as copper.

5. The printed circuit board of claim 1, wherein the adhesive layer (131) includes an alloy containing copper.

6. The printed circuit board of claim 1, wherein the adhesive layer (131) and the first and second via layers include an alloy including copper.

7. The printed circuit board of claim 1, wherein the adhesive layer (131) is formed by aerosol deposition.

8. The printed circuit board of claim 1, further comprising
a third insulating layer (176) on the second insulating layer (150);
a fourth insulating layer (186) under the first insulating layer;
a third via layer (170) formed through the third insulating layer (176) and extending to an upper portion of the second via layer; and
a fourth via layer (180) formed through the fourth insulating layer (186) and extending to a lower portion of the first via layer (110),
wherein the fourth via layer (180) is symmetrical to the section of the third via layer (170) relative to the adhesive layer.

9. The printed circuit board of claim 8, further comprising an additional adhesive layer layers among the first to fourth via layers.

10. The printed circuit board of claim 1, wherein the adhesive layer includes a region extending to the first and second insulating layers.

11. A method for manufacturing a printed circuit board, the method comprising:
• forming first insulated grooves(115) in a first metallic plate (111) except for a region for the formation of a first via layer (110), protrusions between the first insulated grooves (115) constituting the first via layer (110);
• forming holes corresponding to the first via layer (110) in a first insulating layer (120);
• pressing the first insulating layer (120) against the first metallic plate (111), so that the first insulating layer (120) is filled in the first insulating grooves (115) of the first metallic plate (111);
• forming a first metallic layer (130) on the first via layer (110) and the first insulating layer (120);
• etching the first metallic layer (130) except an upper portion of the first via layer 110, thereby forming a first adhesive layer (131);"
• forming second insulated grooves(145) in a second metallic plate (141) except for a region for the formation of a second via layer (140), protrusions between the second insulated grooves (145) constituting the second via layer (140);
• forming holes corresponding to the second via layer (140) in a second insulating layer (150);
• arranging the second metallic plate (141) on the first metallic plate (111) in such a manner that the second insulating grooves (145) faces the first insulating layer (120);
• filling the second insulating layer (150) into the second insulated grooves (145) of the second metallic plate (141) the first insulating layer (120) and the second insulating layer (150) facing each other;
• applying heat and pressure to the first and second metallic plates (111,141);
• etching the first and second metallic plates (111, 141) to expose the first insulating layer (120) and the second insulating layer (150),
wherein the first via layer (110) has a height equal to a height the first insulating layer (120) and the second via layer (140) has a height equal to a height the second insulating layer (150);
wherein the section of the first via layer (110) is symmetrical to the section of the second via layer (140) about the adhesive layer (131); and
wherein each of the first (110) and second via layers (140)is a single layer.

12. The method of claim 11, wherein further comprising
bonding a third metallic plate having a third via layer (170) on the second metallic plater, and bonding a fourth metallic plate having a fourth via layer (180) under the first metallic plate,
wherein each of the second via layer (140) and the third via layer (170) has a sectional shape gradually enlarged toward the upper portion thereof, and each of the first via layer (110) and the fourth layer (180) has a sectional shape gradually enlarged toward the lower portion thereof;
wherein the first via layer (110) and the fourth via layer (180) are symmetrical to the section of the second via layer (140) and the third via layer (170) relative to the adhesive layer (131).

## Patentansprüche

1. Leiterplatte, umfassend:
eine erste Isolierschicht (120);
eine zweite Isolierschicht (150) auf der ersten Isolierschicht; und
eine erste Durchkontaktierungsschicht (110), die durch die erste Isolierschicht (120) hindurch gebildet ist und eine Höhe aufweist, welche gleich einer Höhe der ersten Isolierschicht (120) ist;
eine zweite Durchkontaktierungsschicht (140) auf der ersten Durchkontaktierungsschicht unter Hindurchtreten durch die zweite Isolierschicht (150) und eine Höhe aufweisend, welche gleich einer Höhe der zweiten Isolierschicht (150) ist; und
eine Klebschicht (131) zwischen der ersten und zweiten Durchkontaktierungsschicht, und
wobei der Querschnitt der ersten Durchkontaktierungsschicht (110) zum Querschnitt der zweiten Durchkontaktierungsschicht um die Klebschicht herum symmetrisch ist; und
wobei jede aus der ersten (110) und zweiten Durchkontaktierungsschicht (140) eine einzelne Schicht ist.

2. Leiterplatte nach Anspruch 1, wobei die Querschnitte der ersten und zweiten Durchkontaktierungsschicht breiter sind, wenn die erste und zweite Durchkontaktierungsschicht von der Klebschicht entfernt sind.

3. Leiterplatte nach Anspruch 2, wobei seitliche Seiten der ersten und zweiten Durchkontaktierungsschicht in einer konkaven Form vertieft sind.

4. Leiterplatte nach Anspruch 1, wobei die erste (110) und zweite Durchkontaktierungsschicht (140) ein leitendes Material wie etwa Kupfer einschließen.

5. Leiterplatte nach Anspruch 1, wobei die Klebschicht (131) eine kupferhaltige Legierung einschließt.

6. Leiterplatte nach Anspruch 1, wobei die Klebschicht (131) und die erste und zweite Durchkontaktierungsschicht eine kupferhaltige Legierung einschließen.

7. Leiterplatte nach Anspruch 1, wobei die Klebschicht (131) durch Aerosolabscheidung gebildet ist.

8. Leiterplatte nach Anspruch 1, weiter umfassend
eine dritte Isolierschicht (176) auf der zweiten Isolierschicht (150);
eine vierte Isolierschicht (186) unter der ersten Isolierschicht;
eine dritte Durchkontaktierungsschicht (170), die durch die dritte Isolierschicht (176) hindurch gebildet ist und sich zu einem oberen Abschnitt der zweiten Durchkontaktierungsschicht erstreckt; und
eine vierte Durchkontaktierungsschicht (180), die durch die vierte Isolierschicht (186) hindurch gebildet ist und sich zu einem unteren Abschnitt der ersten Durchkontaktierungsschicht (110) erstreckt,
wobei die vierte Durchkontaktierungsschicht (180) relativ zur Klebschicht zum Querschnitt der dritten Durchkontaktierungsschicht (170) symmetrisch ist.

9. Leiterplatte nach Anspruch 8, weiter eine zusätzliche Klebschicht zwischen der ersten bis vierten Durchkontaktierungsschicht umfassend.

10. Leiterplatte nach Anspruch 1, wobei die Klebschicht einen Bereich einschließt, der sich zur ersten und zweiten Isolierschicht erstreckt.

11. Verfahren zur Herstellung einer Leiterplatte, wobei das Verfahren umfasst:
- Bilden von ersten isolierten Rinnen (115) in einer ersten Metallplatte (111) mit Ausnahme eines Bereichs für die Bildung einer ersten Durchkontaktierungsschicht (110), wobei Erhebungen zwischen den ersten isolierten Rinnen (115) die erste Durchkontaktierungsschicht (110) darstellen;
- Bilden von der ersten Durchkontaktierungsschicht (110) entsprechenden Löchern in einer ersten Isolierschicht (120);
- Pressen der ersten Isolierschicht (120) gegen die erste Metallplatte (111), sodass die erste Isolierschicht (120) in die ersten isolierenden Rinnen (115) der ersten Metallplatte (111) gefüllt wird;
- Bilden einer ersten Metallschicht (130) auf der ersten Durchkontaktierungsschicht (110) und der ersten Isolierschicht (120);
- Ätzen der ersten Metallschicht (130) mit Ausnahme eines oberen Abschnitts der ersten Durchkontaktierungsschicht (110), dadurch Bilden einer ersten Klebschicht (131);
- Bilden von zweiten isolierten Rinnen (145) in einer zweiten Metallplatte (141) mit Ausnahme eines Bereichs für die Bildung einer zweiten Durchkontaktierungsschicht (140), wobei Erhebungen zwischen den zweiten isolierten Rinnen (145) die zweite Durchkontaktierungsschicht (140) darstellen;
- Bilden von der zweiten Durchkontaktierungsschicht (140) entsprechenden Löchern in einer zweiten Isolierschicht (150);
- Anordnen der zweiten Metallplatte (141) auf der ersten Metallplatte (111) in einer derartigen Weise, dass die zweiten isolierten Rinnen (145) der ersten Isolierschicht (120) zugewandt sind;
- Füllen der zweiten Isolierschicht (150) in die zweiten isolierten Rinnen (145) der zweiten Metallplatte (141), wobei die erste Isolierschicht (120) und die zweite Isolierschicht (150) einander zugewandt sind;
- Anlegen von Wärme und Druck an die erste und zweite Metallplatte (111, 141);
- Ätzen der ersten und zweiten Metallplatte (111, 141), um die erste Isolierschicht (120) und die zweite Isolierschicht (150) freizulegen,
wobei die erste Durchkontaktierungsschicht (110) eine Höhe aufweist, die gleich einer Höhe der ersten Isolierschicht (120) ist, und die zweite Durchkontaktierungsschicht (140) eine Höhe aufweist, die gleich einer Höhe der zweiten Isolierschicht (150) ist;
wobei der Querschnitt der ersten Durchkontaktierungsschicht (110) um die Klebschicht (131) herum zum Querschnitt der zweiten Durchkontaktierungsschicht (140) symmetrisch ist; und
wobei jede aus der ersten (110) und zweiten Durchkontaktierungsschicht (140) eine einzelne Schicht ist.

12. Verfahren nach Anspruch 11, wobei weiter umfassend
Bonden einer dritten Metallplatte, die eine dritte Durchkontaktierungsschicht (170) aufweist, auf die zweite Metallplatte, und Bonden einer vierten Metallplatte, die eine vierte Durchkontaktierungsschicht (180) aufweist, unter die erste Metallplatte,
wobei jede aus der zweiten Durchkontaktierungsschicht (140) und der dritten Durchkontaktierungsschicht (170) eine Querschnittsform aufweist, die zum oberen Abschnitt derselben hin zunehmend breiter wird, und jede aus der ersten Durchkontaktierungsschicht (110) und der vierten Schicht (180) eine Querschnittsform aufweist, die zum unteren Abschnitt derselben hin zunehmend breiter wird;
wobei die erste Durchkontaktierungsschicht (110) und die vierte Durchkontaktierungsschicht (180) relativ zur Klebschicht (131) zum Querschnitt der zweiten Durchkontaktierungsschicht (140) und der dritten Durchkontaktierungsschicht (170) symmetrisch sind.

## Revendications

1. Carte de circuit imprimé comprenant :
une première couche isolante (120) ;
une deuxième couche isolante (150) sur la première couche isolante ; et
une première couche de trou d'interconnexion (110) formée à travers la première couche isolante (120) et ayant une hauteur égale à une hauteur de la première couche isolante (120) ;
une deuxième couche de trou d'interconnexion (140) sur la première couche de trou d'interconnexion tout en passant par la deuxième couche isolante (150) et ayant une hauteur égale à une hauteur de la deuxième couche isolante (150) ; et
une couche adhésive (131) entre les première et deuxième couches de trou d'interconnexion, et
dans laquelle la section de la première couche de trou d'interconnexion (110) est symétrique de la section de la deuxième couche de trou d'interconnexion autour de la couche adhésive ; et
dans laquelle chacune des première (110) et deuxième couches de trou d'interconnexion (140) est une monocouche.

2. Carte de circuit imprimé selon la revendication 1, dans laquelle les sections des première et deuxième couches de trou d'interconnexion sont agrandies à mesure que les première et deuxième couches de trou d'interconnexion s'éloignent de la couche adhésive.

3. Carte de circuit imprimé selon la revendication 2, dans laquelle des côtés latéraux des première et deuxième couches de trou d'interconnexion sont évidés selon une forme concave.

4. Carte de circuit imprimé selon la revendication 1, dans laquelle les première (110) et deuxième couches de trou d'interconnexion (140) incluent un matériau conducteur tel que le cuivre.

5. Carte de circuit imprimé selon la revendication 1, dans laquelle la couche adhésive (131) inclut un alliage contenant du cuivre.

6. Carte de circuit imprimé selon la revendication 1, dans laquelle la couche adhésive (131) et les première et deuxième couches de trou d'interconnexion incluent un alliage incluant du cuivre.

7. Carte de circuit imprimé selon la revendication 1, dans laquelle la couche adhésive (131) est formée par dépôt d'aérosol.

8. Carte de circuit imprimé selon la revendication 1, comprenant en outre
une troisième couche isolante (176) sur la deuxième couche isolante (150) ;
une quatrième couche isolante (186) sous la première couche isolante ;
une troisième couche de trou d'interconnexion (170) formée à travers la troisième couche isolante (176) et s'étendant vers une portion supérieure de la deuxième couche de trou d'interconnexion ; et
une quatrième couche de trou d'interconnexion (180) formée à travers la quatrième couche isolante (186) et s'étendant vers une portion inférieure de la première couche de trou d'interconnexion (110),
dans laquelle la quatrième couche de trou d'interconnexion (180) est symétrique de la section de la troisième couche de trou d'interconnexion (170) par rapport à la couche adhésive.

9. Carte de circuit imprimé selon la revendication 8, comprenant en outre une couche adhésive additionnelle entre les première à quatrième couches de trou d'interconnexion.

10. Carte de circuit imprimé selon la revendication 1, dans laquelle la couche adhésive inclut une région s'étendant vers les première et deuxième couches isolantes.

11. Procédé de fabrication d'une carte de circuit imprimé, le procédé comprenant :
- la formation de premières rainures isolées (115) dans une première plaque métallique (111) à l'exception d'une région destinée à la formation d'une première couche de trou d'interconnexion (110), des protubérances entre les premières rainures isolées (115) constituant la première couche de trou d'interconnexion (110) ;
- la formation de trous correspondant à la première couche de trou d'interconnexion (110) dans une première couche isolante (120) ;
- le pressage de la première couche isolante (120) contre la première plaque métallique (111), de sorte que la première couche isolante (120) soit chargée dans les premières rainures isolées (115) de la première plaque métallique (111) ;
- la formation d'une première couche métallique (130) sur la première couche de trou d'interconnexion (110) et la première couche isolante (120) ;
- la gravure de la première couche métallique (130) à l'exception d'une portion supérieure de la première couche de trou d'interconnexion (110), formant ainsi une première couche adhésive (131) ;
- la formation de secondes rainures isolées (145) dans une deuxième plaque métallique (141) à l'exception d'une région destinée à la formation d'une deuxième couche de trou d'interconnexion (140), des protubérances entre les secondes rainures isolées (145) constituant la deuxième couche de trou d'interconnexion (140) ;
- la formation de trous correspondant à la deuxième couche de trou d'interconnexion (140) dans une deuxième couche isolante (150) ;
- l'agencement de la deuxième plaque métallique (141) sur la première plaque métallique (111) de manière à ce que les secondes rainures isolantes (145) soient en regard de la première couche isolante (120) ;
- le chargement de la deuxième couche isolante (150) dans les secondes rainures isolées (145) de la deuxième plaque métallique (141), la première couche isolante (120) et la deuxième couche isolante (150) étant en regard l'une de l'autre ;
- l'application d'une chaleur et d'une pression aux première et deuxième plaques métalliques (111, 141) ;
- la gravure des première et deuxième plaques métalliques (111, 141) pour exposer la première couche isolante (120) et la deuxième couche isolante (150),
dans lequel la première couche de trou d'interconnexion (110) a une hauteur égale à une hauteur de la première couche isolante (120) et la deuxième couche de trou d'interconnexion (140) a une hauteur égale à une hauteur de la deuxième couche isolante (150) ;
dans lequel la section de la première couche de trou d'interconnexion (110) est symétrique de la section de la deuxième couche de trou d'interconnexion (140) autour de la couche adhésive (131) ; et
dans lequel chacune des première (110) et deuxième couches de trou d'interconnexion (140) est une monocouche.

12. Procédé selon la revendication 11, dans lequel comprenant en outre
la liaison d'une troisième plaque métallique ayant une troisième couche de trou d'interconnexion (170) sur la deuxième plaque métallique, et la liaison d'une quatrième plaque métallique ayant une quatrième couche de trou d'interconnexion (180) sous la première plaque métallique,
dans lequel chacune de la deuxième couche de trou d'interconnexion (140) et de la troisième couche de trou d'interconnexion (170) a une forme en coupe s'agrandissant progressivement vers sa portion supérieure, et chacune de la première couche de trou d'interconnexion (110) et de la quatrième couche (180) a une forme en coupe s'agrandissant progressivement vers sa portion inférieure ;
dans lequel la première couche de trou d'interconnexion (110) et la quatrième couche de trou d'interconnexion (180) sont symétriques de la section de la deuxième couche de trou d'interconnexion (140) et de la troisième couche de trou d'interconnexion (170) par rapport à la couche adhésive (131).
